# EUROPÄISCHE PATENTANMELDUNG

(11) **EP 3 825 713 A1**
(43) Veröffentlichungstag der Anmeldung: **26.05.2021**
(21) Anmeldenummer: 19210942.9
(22) Anmeldetag: 22.11.2019
(51) Int. Cl.: G01R 33/561, G01R 33/48

(54) **VERFAHREN ZUR QUANTITATIVEN MAGNETRESONANZBILDGEBUNG VON UNTERSCHIEDLICHEN SPINARTEN MITTELS MAGNETRESONANZFINGERPRINTING**

(71) Anmelder: Siemens Healthcare GmbH, 91052 Erlangen (DE)
(72) Erfinder: Grodzki, David, 91058 Erlangen (DE); Körzdörfer, Gregor, 91058 Erlangen (DE); Nittka, Mathias, 91083 Baiersdorf (DE)

(57) **Zusammenfassung**

Verfahren zur quantitativen Magnetresonanzbildgebung, wobei wenigstens eine Aufnahmeserie von Magnetresonanzbildern (3, 4) eines Untersuchungsbereichs, der zwei unterschiedliche Spinarten, deren Larmorfrequenzen sich unterscheiden, insbesondere in Fett gebundene Protonen und in Wasser gebundene Protonen, aufweist, in Repetitionen (1) einer Magnetresonanzsequenz, die für jede Repetition (1) unterschiedliche Aufnahmeparameter nutzt, mit einer Magnetresonanzeinrichtung (28) aufgenommen wird, wobei in einer Fingerprintingauswertung (22) zur Ermittlung quantitativer Parameter (25) des Untersuchungsbereichs aus der Aufnahmeserie ermittelte Signalverläufe mit wenigstens aus einer Datenbank (23) ermittelten Vergleichsverläufen verglichen werden, wobei während jeder Repetition (1) wenigstens zwei Magnetresonanzbilder (3, 4) bei unterschiedlichen Echozeiten (5, 6), bei denen unterschiedliche relative Phasenlagen der Magnetisierung der Spinarten, insbesondere der in Fett gebundenen Protonen und der in Wasser gebundenen Protonen, vorliegen, aufgenommen werden.

## Beschreibung

Die Erfindung betrifft ein Verfahren zur quantitativen Magnetresonanzbildgebung, wobei wenigstens eine Aufnahmeserie von Magnetresonanzbildern eines Untersuchungsbereichs, der zwei unterschiedliche Spinarten, deren Larmorfrequenzen sich unterscheiden, insbesondere in Fett gebundene Protonen und in Wasser gebundene Protonen, aufweist, in Repetitionen einer Magnetresonanzsequenz, die für jede Repetition unterschiedliche Aufnahmeparameter nutzt, mit einer Magnetresonanzeinrichtung aufgenommen wird, wobei in einer Fingerprintingauswertung zur Ermittlung quantitativer Parameter des Untersuchungsbereichs aus der Aufnahmeserie ermittelte Signalverläufe mit wenigstens aus einer Datenbank ermittelten Vergleichsverläufen verglichen werden. Daneben betrifft die Erfindung eine Magnetresonanzeinrichtung, ein Computerprogramm und einen elektronisch lesbaren Datenträger.

Insbesondere in der medizinischen Diagnostik stellt die Magnetresonanzbildgebung inzwischen eine etablierte Modalität dar. Hierbei war es bislang gängig, qualitativ gewichtete Magnetresonanzbilder aufzunehmen, beispielsweise T1-gewichtete, T2-gewichtete und/oder protonendichtegewichtete Magnetresonanzbilder. Inzwischen wurden jedoch auch Methoden zur quantitativen Magnetresonanzbildgebung vorgeschlagen, um als Ergebnis beispielsweise eine quantitative Messkarte zu erhalten, in der voxelweise Relaxationszeiten oder sonstige Parameter, die das Magnetresonanzverhalten eines in dem Voxel vorliegenden Materials beschreiben, abgebildet werden. Insbesondere kann aufgrund der Parameter auch das Material selbst, das in dem Voxel vorliegt, ermittelt werden.

Ein bekanntes quantitatives Magnetresonanzbildgebungsverfahren ist das sogenannte Magnetresonanz-Fingerprinting (MRF), mit dem in einer Messung voxelweise mehrere physikalische Parameter/Werte gleichzeitig gemessen werden können, beispielsweise die Relaxationszeiten T1 und T2. Bei bekannten Vorgehensweisen werden bevorzugt mit einer Einzelschuss-Bildgebungstechnik eine große Zahl von Magnetresonanzbildern als eine Aufnahmeserie nacheinander akquiriert, wobei jeweils ein Magnetresonanzbild durch Abtasten einer entsprechenden k-Raumtrajektorie in einer Repetition, deren Dauer durch die Repetitionszeit (TR) gekennzeichnet ist, mit einer Magnetresonanzsequenz aufgenommen wird. Die Besonderheit ist jedoch, dass sich von Repetition zu Repetition Aufnahmeparameter, wie beispielsweise der Flipwinkel, pseudorandomisiert geändert werden, so dass abhängig von den physikalischen Eigenschaften in den durch die Voxel vermessenen Bereichen bestimmte Signalverläufe über die Aufnahmeserie von Magnetresonanzbildern entstehen. Diese Signalverläufe, die auch als Fingerabdrücke bezeichnet werden, können durch Abgleich mit Vergleichsverläufen in Datenbanken (sogenannten "Dictionaries") einem n-Tupel physikalischer Ergebniswerte, also quantitativer Parameter, zugeordnet werden. Gegebenenfalls kann ein Material in dem Voxel aufgrund der Ergebniswerte identifiziert werden.

Zur Ermittlung geeigneter Datenbanken (Dictionaries) kann beispielsweise vorgesehen sein, dass eine Berechnung und/oder Simulation aufgrund der Blochgleichungen stattfindet, um die Vergleichsverläufe (als "Vergleichsfingerabdrücke") zu ermitteln.

Insbesondere bei der Anwendung in der medizinischen Bildgebung, also bei der Aufnahme von Untersuchungsbereichen von Patienten, enthalten viele Gewebetypen und somit viele Materialien in vermessenen Voxeln Anteile von Fett. Das Magnetresonanzsignal von in Fett gebundenen Protonen unterscheidet sich von dem Magnetresonanzsignal von in Wasser gebundenen Protonen durch eine unterschiedliche Resonanzfrequenz Larmorfrequenz, wobei der Unterschied zwischen diesen Larmorfrequenzen auch als chemische Verschiebung oder "Offresonanz" bezeichnet wird. Diese chemische Verschiebung kann beim Magnetresonanz-Fingerprinting zu fehlerhaften Ergebnissen führen, falls keine besonderen Maßnahmen getroffen werden. Beispielsweise führt der Frequenz-Offset der chemischen Verschiebung zu einer falschen räumlichen Zuordnung, beispielsweise einer Voxelverschiebung bei kartesischer k-Raum-Abtastung, beziehungsweise zu Bildartefakten, beispielsweise Blurring bei nicht-kartesischer Abtastung des k-Raums.

Im Stand der Technik bekannt ist bereits die Anwendung von Fettunterdrückungs-Methoden in Verfahren zur quantitativen Magnetresonanzbildgebung. Zur Unterdrückung des Fettsignals werden dabei Präparationspulse und/oder frequenzselektive Hochfrequenzpulse, die nur auf in Wasser gebundenen Protonen wirken, verwendet.

Vorgeschlagen wurde im Stand der Technik auch bereits, beim Magnetresonanz-Fingerprinting Echos mit verschiedenen Echozeiten TE zu vermessen, wodurch sich aus den Phasendifferenzen Fett- und Wasseranteile berechnen lassen. In der allgemeinen Magnetresonanzbildgebung ist diese Vorgehensweise als Dixon-Technik bekannt. Beispielsweise ist es bei Vorliegen von zwei Magnetresonanzbildern unterschiedlicher relativer Phasenlage zwischen den Magnetresonanzsignalen von in Fett gebundenen Protonen und von in Wasser gebundenen Protonen möglich, ein Wasserbild, das nur die Wasseranteile zeigt, und ein Fettbild, das nur die Fettanteile zeigt, zu ermitteln, wenn die Phasenlagen zu den verschiedenen Echozeiten unterschiedlich und bekannt sind.

In dem Artikel "Magnetic resonance fingerprinting with dictionary-based fat and water separation (DBFW MRF): A multicomponent approach" von Matteo Cencini et al., Magn. Reson. Med. 81 (2019), Seiten 3032 - 3045, werden zwei grundlegende Herangehensweisen zur Fett-Wasser-Trennung beim Magnetresonanz-Fingerprinting verglichen. Die grundlegende Idee ist es, zunächst Magnetresonanzbilder mit unterschiedlichen Echozeiten TE aufzunehmen, wobei von Repetition zu Repetition die Echozeit verändert wird. Während die dort als Vergleich herangezogene Vorgehensweise vorsieht, nun eine Dixon-Technik anzuwenden, um Wasserbilder und Fettbilder zu erzeugen, die dann jeweils mit einer reinen Wasser-Datenbank (Wasser-Dictionary) und einer reinen Fett-Datenbank (Fett-Dictionary) ausgewertet werden, schlägt die dort neue Vorgehensweise vor, die reine Fett-Datenbank und die reine Wasser-Datenbank zu einer gemeinsamen Fett-Wasser-Datenbank (Fett-Wasser-Dictionary) zu kombinieren, welche neben der T1-Relaxationszeit für Wasser und der T1-Relaxationszeit für Fett auch die chemische Verschiebung und den Fettanteil zurückliefern kann, um eine schnelle und robuste Fett-Wasser-Trennung mit gleichzeitiger Ermittlung der T1-Relaxationszeiten sowohl für Fett als auch für Wasser zu erreichen.

Der Erfindung liegt die Aufgabe zugrunde, ein quantitatives Magnetresonanzbildgebungsverfahren, welches eine Spinartentrennung, insbesondere Fett-Wasser-Trennung, erlaubt, mit verbesserter Abtastungs-Effizienz bereitzustellen.

Diese Aufgabe wird erfindungsgemäß gelöst durch ein Verfahren, eine Magnetresonanzeinrichtung, ein Computerprogramm und einen elektronisch lesbaren Datenträger gemäß den unabhängigen Ansprüchen. Vorteilhafte Weiterbildungen ergeben sich aus den abhängigen Ansprüchen.

In einem Verfahren der eingangs genannten Art ist erfindungsgemäß vorgesehen, dass während jeder Repetition wenigstens zwei Magnetresonanzbilder bei unterschiedlichen Echozeiten, bei denen unterschiedliche relative Phasenlagen der Magnetisierung der Spinarten, insbesondere der in Fett gebundenen Protonen und der in Wasser gebundenen Protonen, vorliegen, aufgenommen werden.

Die folgenden Ausführungen werden sich hauptsächlich auf die Spins von in Wasser gebundenen Protonen als die eine Spinart und die Spins von in Fett gebundenen Protonen als die andere Spinart beziehen, doch die Erfindung ist auch auf andere Fälle von chemischer Verschiebung anwendbar. Wesentlich ist, dass hinreichend unterschiedliche relative Phasenlagen zwischen den Spins der ersten Spinart und den Spins der zweiten Spinart innerhalb einer Repetition erhaltbar sind.

Dabei wird ein Fingerprinting-Verfahren weitergebildet, so dass die Magnetresonanzsequenz auch als eine Fingerprintingsequenz (MRF-Sequenz) bezeichnet werden kann. Insbesondere wird im Rahmen der vorliegenden Erfindung also ein Nichtgleichgewichts-Aufnahmeschema (Non-Steady-State-Aufnahmeschema) genutzt, wie es auch typischerweise bei Fingerprinting-Sequenzen verwendet wird. In Ausgestaltungen der Erfindung ist es auch denkbar, dass die Magnetresonanzbilder Teilbilder sind, insbesondere, wenn keine hinreichende k-Raumabdeckung in einer Repetition möglich ist, so dass bei der Ermittlung des Signalverlaufs auch mehrere Repetitionen gemeinsam betrachtet werden können, in denen unterschiedliche k-Raumbereiche abgetastet wurden. Denkbar ist es aber selbstverständlich auch, insbesondere bei Radialtrajektorien, dass eine Repetition ausreichend ist, um den k-Raum hinreichend abzutasten.

Die Erfindung schlägt in anderen Worten wird vor, mehrere Echos innerhalb einer Repetitionszeit (TR), also innerhalb einer Repetition, aufzunehmen, wodurch sich eine besonders hohe Abtastungs-Effizienz ergibt, da eine hohe k-Raum-Abdeckung pro Zeit gegeben ist, ein hohes Signal-zu-Rauschverhältnis pro Zeit sowie eine geringe SAR-Belastung pro Zeit. Dies steht im Gegensatz zum Stand der Technik, bei dem bislang unterschiedliche Echozeiten TE in unterschiedlichen Repetitionen vermessen wurden.

Gemäß der Erfindung wird nun eine Abfolge von zwei oder mehr Gradientenechos mit unterschiedlichen Echozeiten nach einer Hochfrequenz-Anregung umgesetzt, wobei diese Echozeiten so gewählt sind, dass eine unterschiedliche Phasenbeziehung zwischen dem Magnetresonanzsignal der Spinarten, insbesondere der in Fett gebundenen Protonen und der in Wasser gebundenen Protonen vorliegt. Dies ermöglicht es, die aus den unterschiedlichen Echozeiten resultierende Phaseninformation zu verwenden, insbesondere um eine Fett-Wasser-Trennung durchzuführen, wobei, worauf im Folgenden noch näher eingegangen werden wird, eine Dixon-Technik verwendet werden kann, bevorzugt jedoch die im Artikel von Cencini et al. vorgeschlagene Gesamt-Datenbank (Fett-Wasser-Dictionary) genutzt wird. Bei dieser letzten Ausgestaltung kann also gesagt werden, dass die Datenbank um eine Phasen-Dimension erweitert ist, um zwischen den Spinarten, insbesondere Fett und Wasser, unterscheiden zu können.

Die Magnetresonanzbilder, die innerhalb eines TR aufgenommen werden, werden entlang einer bestimmten k-Raumtrajektorie abgetastet, die für die unterschiedlichen Magnetresonanzbilder gleich sein kann, jedoch auch Unterschiede aufweisen kann. Die Herausforderung ist es nun, bei hinreichend guter Auflösung, mithin Ausdehnung des abgetasteten k-Raums, mehrere Echozeiten innerhalb einer Repetitionszeit zu vermessen, bevor das Magnetresonanzsignal zerfallen ist beziehungsweise ein Phasen-Wrap aufgetreten ist. Während es diesbezüglich grundsätzlich denkbar ist, verkürzte k-Raumtrajektorien zu nutzen, sieht eine besonders vorteilhafte Weiterbildung der vorliegenden Erfindung vor, die Eigenschaften von Niedrigfeld-Umgebungen auszunutzen.

So kann in einer besonders bevorzugten Ausgestaltung der vorliegenden Erfindung vorgesehen sein, dass eine Magnetresonanzeinrichtung mit einem Grundmagnetfeld verwendet wird, dessen Stärke bei weniger oder gleich 1 T, bevorzugt weniger als oder gleich 0,75 T, besonders bevorzugt weniger als oder gleich 0,6 T, liegt. Bei Magnetresonanzeinrichtungen mit sehr niedriger Feldstärke, insbesondere also sehr viel kleiner als 1,5 T, treten zwei Effekte hinsichtlich des Zeitablaufs auf, die im Rahmen der vorliegenden Erfindung besonders vorteilhaft genutzt werden können. So liegen zum einen die Echozeiten, bei denen sich die Phasen des Magnetresonanzsignals von in Fett gebundenen Protonen und von in Wasser gebundenen Protonen (Fettsignal beziehungsweise Wassersignal) gleichen und bei denen die Phasen von Fettsignal und Wassersignal entgegengesetzt sind, weiter auseinander, wodurch hinreichend lange k-Raumtrajektorien und somit Auslesezeitfenster, insbesondere von mehreren Millisekunden Länge, zwischen diesen Zeitpunkten möglich sind. Das Übereinstimmen der Phasen des Fettsignals und des Wassersignals wird auch als In-Phase-Bedingung bezeichnet, das Vorliegen exakt entgegengesetzter Phasen des Fettsignals und des Wassersignals auch als Opposed-Phase-Bedingung. Ein zweiter Vorteil bei Magnetresonanzeinrichtungen mit sehr niedrigen Feldstärken ist, dass die T2*-Dephasierung geringer ist, mithin für eine längere Zeit überhaupt ausgelesen werden kann. Mit anderen Worten ermöglicht es die verlangsamte T2*-Relaxation bei niedrigen Feldstärken, mehrere Gradientenechos aufzunehmen, ohne dass das Wassersignal und das Fettsignal in dieser Zeit dephasieren. Diese Ausführungen gelten auch für sonstige unterschiedliche Spinarten.

In einem Beispiel kann die Feldstärke der Magnetresonanzeinrichtung 0,5 T betragen. Dann wird die erste Opposed-Phase-Bedingung bei ca. 7 ms erreicht, die erste In-Phase-Bedingung bei ca. 14 ms. Eine optimale Echofolge könnte ein erstes Magnetresonanzbild bei einer Echozeit von etwa 7 ms realisieren und ein zweites Magnetresonanzbild bei einer Echozeit von etwa 14 ms. Eine Auslese-Gesamtzeit in dieser Größenordnung erscheint aufgrund der geringen T2*-Dephasierung möglich.

Somit ist es im Rahmen der vorliegenden Erfindung möglich, die Eigenschaften von Messungen bei niedrigen Feldstärken optimal auszunutzen, insbesondere die verlängerte Zeitdifferenz zwischen der In-Phase-Bedingung und der Opposed-Phase-Bedingung. So können weiterhin hinreichend lange k-Raumtrajektorien genutzt werden, was bei höheren Feldstärken aufgrund der deutlich geringeren bereitstehenden Zeit nicht möglich wäre.

Zweckmäßigerweise können wenigstens zwei der Echozeiten so gewählt werden, dass die Magnetisierung der Spinarten, insbesondere der in Fett gebundenen Protonen und der in Wasser gebundenen Protonen, einmal in Phase und einmal in Gegenphase vorliegt. Mit anderen Worten können wenigstens zwei der Echozeiten so gewählt werden, dass die soeben beschriebene In-Phase-Bedingung beziehungsweise die soeben beschriebene Opposed-Phase-Bedingung erfüllt sind. Das Timing der Echos wird mithin optimalerweise so gewählt, dass die In-Phase-Bedingung und die Opposed-Phase-Bedingung möglichst gut erfüllt werden, um eine möglichst stabile Fett-Wasser-Trennung zu erreichen. Mit anderen Worten kann auch etwas allgemeiner formuliert werden, dass die Echozeiten der einzelnen Magnetresonanzbilder so gewählt werden, dass eine möglichst große Phasendifferenz zwischen den beiden Echos in Bezug auf Fett- und Wassersignale erreicht wird, um diese möglichst gut trennen zu können.

In einer besonders bevorzugten Weiterbildung der vorliegenden Erfindung können als Aufnahmetrajektorien für die Magnetresonanzbilder Spiraltrajektorien verwendet werden. Spiraltrajektorien verlaufen üblicherweise vom k-Raumzentrum bis zu einem äußeren Punkt des k-Raums in einer Spirale und können sowohl vom k-Raumzentrum aus als auch vom äußeren Punkt aus, dann mithin am k-Raumzentrum endend, durchlaufen werden. Dabei bestimmt sich die Echozeit üblicherweise an dem Zeitpunkt, in dem das (den Kontrast bestimmende) k-Raumzentrum abgetastet wird. Spiraltrajektorien bieten die höchste Effizienz bezüglich der Ortskodierung, konkret der Abdeckung des k-Raums pro Zeit. Mit anderen Worten wird durch eine Spiraltrajektorie ein möglichst großer Anteil des k-Raums in möglichst geringer Zeit abgetastet, weshalb sie sich besonders für die Anwendung im Rahmen der vorliegenden Erfindung eignen.

Vorteilhafterweise können die Spiraltrajektorien verschiedener Magnetresonanzbilder im k-Raum unmittelbar aneinander anschließen. Dabei wird eine weitere Eigenschaft von Spiraltrajektorien benutzt, nämlich dass diese nahtlos aneinandergefügt werden können, so dass wiederum kein Zeitverlust durch eine neue Startposition im k-Raum anwählende Gradienten (Rewinder-Gradienten) eintritt.

In konkreter Ausgestaltung der vorliegenden Erfindung kann beispielsweise eine nach außen durchlaufene Spirale für ein erstes Magnetresonanzbild und eine nach innen durchlaufene Spirale für ein zweites, unmittelbar folgendes Magnetresonanzbild verwendet werden. In diesem Fall wird also im k-Raumzentrum begonnen, so dass die Echozeit dem Startpunkt des entsprechenden Auslesezeitraums entspricht. Eine derart durchlaufene Spiraltrajektorie kann auch als _{"}Spiral-out" bezeichnet werden. Dem _{"}Spiral-out" folgt nun eine nach innen durchlaufene Spiraltrajektorie, mithin ein "Spiral-in", beidem die Spiraltrajektorie am Endpunkt der vorherigen Spiraltrajektorie außen im k-Raum beginnt und ihre effektive Echozeit am Ende des Auslesezeitraums, wenn das k-Raumzentrum erreicht wird, aufweist.

In einer anderen Ausgestaltung kann auch vorgesehen sein, dass eine Abfolge von nach innen und nach außen verlaufenden Spiralen für ein erstes Magnetresonanzbild und eine nach innen verlaufende Spirale für ein zweites, unmittelbar folgendes Magnetresonanzbild verwendet werden. In diesem Fall wird also, insbesondere bereits kurz nach der Anregung und bevor die erste Opposed-Phase-Bedingung erreicht ist, mit dem Auslesezeitraum für das erste Magnetresonanzbild außen im k-Raum derart begonnen, dass nach Durchlaufen einer ersten, am k-Raumzentrum endende Spirale die erste Echozeit (und somit insbesondere die Opposed-Phase-Bedingung) erreicht ist. Nun setzt eine nach außen verlaufende Spiraltrajektorie (Spiralout) an, bis wieder ein Punkt außen im k-Raum erreicht ist, wobei an dieser Stelle die Vermessung für das erste Magnetresonanzbild endet, welches mithin durch das Verlaufen von zwei vollständigen Spiraltrajektorien eine große Datenbasis aufweist. Idealerweise endet das _{"}Spiral-out" zu einem Zeitpunkt mittig zwischen den beiden Echozeiten, insbesondere also mittig zwischen der Opposed-Phase-Bedingung und der In-Phase-Bedingung. Nun setzt als ein "Spiral-in" eine weitere Spiraltrajektorie für die Abtastung des k-Raums für das zweite Magnetresonanzbild an, welche idealerweise mit Vorliegen der In-Phase-Bedingung im k-Raumzentrum endet. Auf diese Weise wird der nach der Anregung zum Auslesen bereitstehende Zeitraum besonders effektiv genutzt.

Im Rahmen der vorliegenden Erfindung ist es grundsätzlich auch denkbar, dass eine kartesische oder eine radiale Abtastung des k-Raums erfolgt, wobei dies allerdings aufgrund der geringeren Effizienz bezüglich der Abtastung wenigere bevorzugt ist. Denkbar wäre es beispielsweise, bei der Verwendung von radialen Speichen ("Spokes") eine radiale Speiche in zwei unterschiedlichen Richtungen zu durchlaufen, um die wenigstens zwei Magnetresonanzbilder zu erhalten.

Als Ergebnis der Fingerprinting-Auswertung kann für wenigstens einen Teil der in den Magnetresonanzbildern abgebildeten Voxel wenigstens ein Spinartenanteil, insbesondere ein Fettanteil und/oder ein Wasseranteil, und/oder wenigstens ein das Magnetresonanzverhalten beschreibender Parameter für nur eine Spinart, insbesondere nur den Fettanteil und/oder nur den Wasseranteil, ermittelt werden. Als Ergebniswerte sind beispielsweise T1-Relaxationszeiten, T2-Relaxationszeiten, insbesondere aufgeschlüsselt nach Wasser und Fett, denkbar, während auch beispielsweise ein Fettanteil pro Voxel einen Ergebniswert der Fingerprinting-Auswertung darstellen kann. Alternativ oder zusätzlich ist es ferner denkbar, dass die Magnetresonanzbilder einer Repetition zur Ermittlung eines Wasseranteils und/oder eines Fettanteils des vermessenen Signals gemäß einer Dixon-Technik ausgewertet werden. Beispielsweise ist es in diesem Zusammenhang denkbar, Fettbilder und/oder Wasserbilder zu ermitteln und/oder für jedes Voxel einen Fettanteil und/oder einen Wasseranteil zu bestimmen. Der Wasseranteil und/oder der Fettanteil für jedes Voxel können als Teil des Signalverlaufs und/oder zusätzlich zu Signalverläufen in die Fingerprinting-Auswertung ausgehen; möglich ist es ferner, eine reine Wasser-Datenbank und eine reine Fettdatenbank zu verwenden, wobei als Eingangsdaten für die Fingerprinting-Auswertung jeweils aus den Wasserbildern beziehungsweise den Fettbildern ermittelte Signalverläufe für jedes Voxel herangezogen werden können. Zu den Details bezüglich der Auswertungsoptionen wird im Übrigen wiederum auf den eingangs zitierten Artikel von Cencini et al. verwiesen.

Allgemein kann also gesagt werden, dass die Fingerprinting-Auswertung bevorzugt aufgrund der Magnetresonanzbilder unterschiedlicher Echozeiten zwischen Fett und Wasser unterscheidet und/oder Fettanteil und/oder Wasseranteil, insbesondere als Ergebniswert/quantitativer Parameter, liefert.

Neben dem Verfahren betrifft die Erfindung auch eine Magnetresonanzeinrichtung, aufweisend eine zur Durchführung eines erfindungsgemäßen Verfahrens ausgebildete Steuereinrichtung mit wenigstens einem Prozessor und wenigstens einem Speichermittel. Sämtliche Ausführungen bezüglich des erfindungsgemäßen Verfahrens lassen sich analog auf die erfindungsgemäße Magnetresonanzeinrichtung übertragen, so dass auch mit dieser die bereits genannten Vorteile erhalten werden können.

Insbesondere kann die Magnetresonanzeinrichtung, insbesondere realisiert durch den wenigstens einen Prozessor durch Nutzung wenigstens eines Programmmittels und/oder durch eigene Hardwaremittel, aufweisen:
- eine Sequenzeinheit, wie grundsätzlich bekannt, zur Aufnahme der Magnetresonanzbilder,
- eine Parametrierungseinheit zur Ermittlung wenigstens der Echozeiten zur Verwendung in der Sequenzeinheit, und
- eine Auswerteeinheit zur Durchführung der Fingerprinting-Auswertung.

Ferner kann die Steuereinrichtung auch eine Schnittstelle zur Ausgabe der quantitativen Parameter, also Ergebniswerte, der Fingerprinting-Auswertung aufweisen.

Ein erfindungsgemäßes Computerprogramm ist beispielsweise direkt in ein Speichermittel einer Steuereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird. Das Computerprogramm kann auf einem erfindungsgemäßen elektronisch lesbaren Datenträger gespeichert sein, welcher mithin darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzeinrichtung ein erfindungsgemäßes Verfahren durchführen. Bei dem Datenträger handelt es sich insbesondere um einen nichttransienten Datenträger, beispielsweise eine CD-ROM.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine schematische Darstellung des Ablaufs eines Ausführungsbeispiels des erfindungsgemäßen Verfahrens,
- Fig. 2: ein erstes schematisches Sequenzdiagramm,
- Fig. 3: ein zweites schematisches Sequenzdiagramm,
- Fig. 4: eine erfindungsgemäße Magnetresonanzeinrichtung, und
- Fig. 5: den funktionalen Aufbau der Steuereinrichtung der Magnetresonanzeinrichtung gemäß Fig. 4.

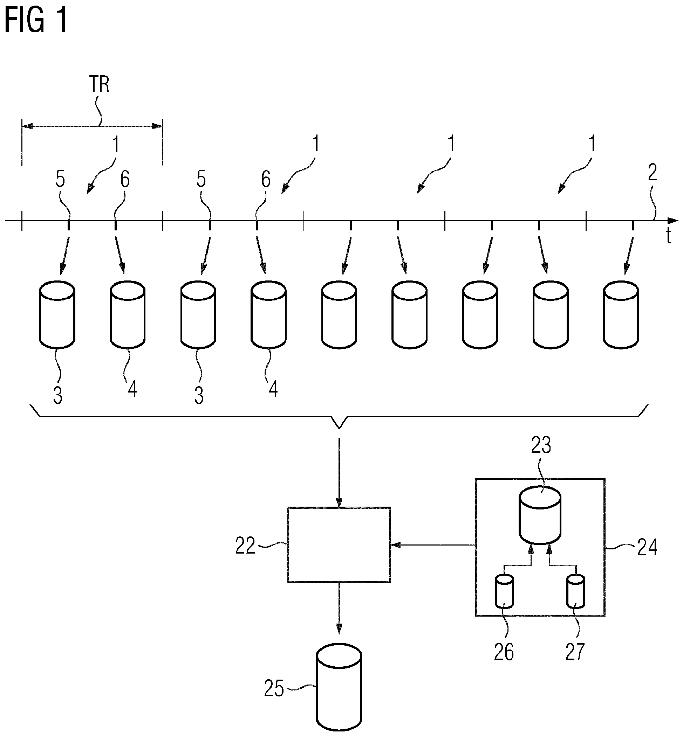

Fig. 1 zeigt ein schematisches Diagramm zum Ablauf eines Ausführungsbeispiels des erfindungsgemäßen Verfahrens zur quantitativen Magnetresonanzbildgebung. Die Messzeit ist dabei, wie grundsätzlich bekannt, in Repetitionen 1 unterteilt, wie entlang der Zeitachse 2 schematisch dargestellt ist. Die Repetitionen 1 dauern jeweils für eine Repetitionszeit TR an und umfassen jeweils einen Hochfrequenz-Anregungspuls. Im Unterschied zu herkömmlichen Fingerprinting-Datenaufnahmen werden vorliegend innerhalb jeder Repetition 1 zwei Magnetresonanzbilder 3, 4 aufgenommen, jeweils zu unterschiedlichen Echozeiten 5, 6, mit anderen Worten zwei Gradientenechos vermessen. Jedes der Magnetresonanzbilder 3, 4 wird dabei entlang einer k-Raumtrajektorie aufgenommen, die vorliegend gegenüber üblichen Fingerprinting-Aufnahmevorgängen nicht verkürzt wurde. Dabei wurde ausgenutzt, dass vorliegend eine Magnetresonanzeinrichtung verwendet wird, die mit einem Grundmagnetfeld einer Stärke von lediglich 0,5 T arbeitet, so dass zum einen die T2*-Dephasierung deutlich langsamer als bei höheren Feldern stattfindet, mithin ein größeres Zeitfenster zur Aufnahme von Magnetresonanzsignalen zur Verfügung steht, zum anderen aber die In-Phase-Bedingung und die Opposed-Phase-Bedingung bezüglich des Wassersignals und des Fettsignals zeitlich weiter auseinanderliegen. Entsprechend bezieht sich auch im Ausführungsbeispiel der Fig. 1 die erste Echozeit 5 auf das erste Vorliegen der Opposed-Phase-Bedingung, die zweite Echozeit 6 auf das erste Vorliegen der In-Phase-Bedingung, so dass ein maximaler Unterschied der relativen Phase besteht, der später genutzt werden kann, um eine explizite oder implizite Fett-Wasser-Trennung durchzuführen.

Bei der genannten Feldstärke von 0,5 T kann beispielsweise die erste Echozeit 5 ungefähr bei 7 ms liegen, die zweite Echozeit 6 beispielsweise bei ca. 14 ms.

Dabei sei an dieser Stelle noch angemerkt, dass sich von Repetition 1 zu Repetition 1 Aufnahmeparameter der Magnetresonanzsequenz, beispielsweise der Flipwinkel und dergleichen, grundsätzlich verändern, wobei es gegebenenfalls auch zu weiteren und/oder anderen Echozeiten 5, 6 kommen kann. Auch allgemein gilt, dass die Vermessung von zwei Echos, mithin zwei Magnetresonanzbildern 3, 4 pro Repetition 1 in Fig. 1, nur beispielhaft ist, es sind auch Ausführungsbeispiele denkbar, in denen drei oder mehr Magnetresonanzbilder 3, 4 vermessen werden, um weitere Informationen über die Phasenevolution, insbesondere hinsichtlich der relativen Phase des Wassersignals und des Fettsignals, zu erlauben.

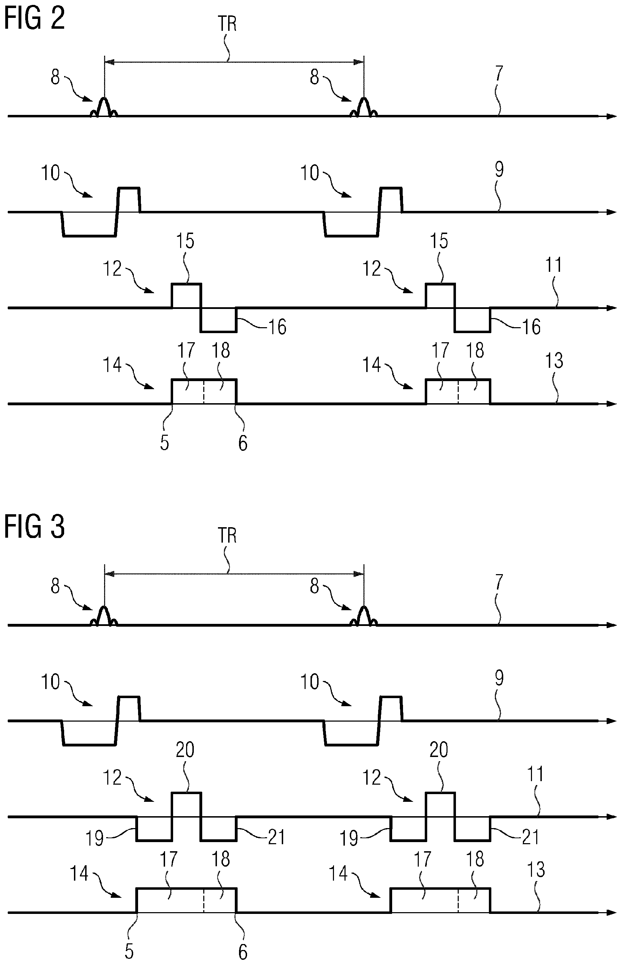

Die Figuren 2 und 3 zeigen anhand von schematischen Sequenzdiagrammen mögliche konkrete Umsetzungen zur Aufnahme von zwei Magnetresonanzbildern 3, 4 während einer Repetition 1. Beide Figuren zeigen im obersten Graphen 7 die Hochfrequenzpulse 8, die als Anregungspulse dienen, im oberen mittleren Graphen 9 die Schichtselektionsgradienten 10, im unteren mittleren Graphen 11 die die k-Raumtrajektorie bestimmenden Auslesegradienten 12 schematisch und im untersten Graphen 13 das die Auslesezeiträume 14 bestimmende ADC-Signal.

In der ersten Ausführungsform gemäß der Fig. 2 werden, im Graphen 11 vereinfacht dargestellt, eine Spiraltrajektorie realisierende Gradientenpulsgruppen 15, 16, wie sie im Stand der Technik grundsätzlich bekannt sind, eingesetzt. Die positiv gezeigte Gradientenpulsgruppe 15 entspricht dabei einer im k-Raumzentrum beginnenden und nach außen durchlaufenen Spiraltrajektorie, die an einem äußeren Punkt des k-Raums endet. Die negativ dargestellte Gradientenpulsgruppe 16 entspricht einer an dem äußeren Punkt beginnenden Spiraltrajektorie, die nach innen durchlaufen wird, um am k-Raumzentrum zu enden. Dies wird im Folgenden auch als "Spiral-out" (Gradientenpulsgruppe 15) und "Spiral-in" (Gradientenpulsgruppe 16) bezeichnet.

Wie die Unterteilung des Auslesezeitfensters 14 zeigt, werden dabei während der ersten Spiraltrajektorie in einem Zeitraum 17 Magnetresonanzdaten für das erste Magnetresonanzbild 4 aufgenommen, während des Durchlaufens der zweiten Spiraltrajektorie in einem zweiten Zeitraum 18 Magnetresonanzdaten des zweiten Magnetresonanzbildes 4. Die Echozeiten 5, 6 entsprechen dem Beginn und dem Ende des Auslesezeitfensters 14, wenn das jeweilige k-Raumzentrum ausgelesen wird.

In der Ausführungsform gemäß Fig. 3 wird ersichtlich eine andere Abfolge von in diesem Fall drei Gradientenpulsgruppen 19, 20, 21 verwendet, wobei zunächst mit einer "Spiral-in"-Gradientenpulsgruppe 19 begonnen wird, auf die, unmittelbar in eine weitere Spiraltrajektorie übergehend, die "Spiralout"-Gradientenpulsgruppe 20 folgt, an welchen nahtlos mit der "Spiral-in"-Gradientenpulsgruppe 21 eine weiterer Spiraltrajektorie anschließt. Die beiden ersten Spiraltrajektorien dienen dabei jeweils, vgl. den Zeitraum 17, zur Aufnahme von Magnetresonanzdaten für das erste Magnetresonanzbild 3, während nur während der letzten Spiraltrajektorie Magnetresonanzdaten für das zweite Magnetresonanzbild 4 aufgenommen werden. Der Vorteil der Ausgestaltung nach Fig. 3 ist, dass die erste Echozeit 5, mithin der Durchgang durch das k-Raumzentrum, mittig im Zeitraum 17 liegt, mithin bereits deutlich früher mit der Datenaufnahme begonnen werden kann und somit eine effizientere Nutzung des Messzeitraums zur Ermittlung zusätzlicher Daten besteht.

Es versteht sich, dass die Gradientenpulsgruppe 19 entsprechend auch Gradientenanteile enthält, um den äußeren Punkt, an dem die Spiraltrajektorie im k-Raum startet, anzufahren.

Zurückkehrend zu Fig. 1 werden sämtliche aufgenommenen ersten und zweiten Magnetresonanzbilder 4 aller Repetitionen 1 vorliegend genutzt, um in einer Fingerprinting-Auswertung 22 Signalverläufe für jedes Voxel zu erstellen, welche mit Vergleichsverläufen aus einer gemeinsamen Fett-Wasser-Datenbank 23, die in einem Speichermittel 24 gespeichert ist, abgeglichen werden, um quantitative Parameter 25, die den Vergleichsverläufen zugeordnet sind, als Ergebniswerte zu bestimmen. Die Fett-Wasser-Datenbank 23, die auch als Fett-Wasser-Dictionary bezeichnet werden kann, kann dabei, wie beispielsweise im eingangs zitierten Artikel von Cencini et al. beschrieben, aus einer reinen Fett-Datenbank 26 (Fett-Library) und einer reinen Wasser-Datenbank (Wasser-Library) erzeugt werden, wobei es jedoch auch denkbar ist, die Datenbank 23 direkt zu erzeugen.

Als Ergebniswerte 25 kann die Fingerprinting-Auswertung 22 beispielsweise T1-Relaxationszeiten für Fett und Wasser, T2-Relaxationszeiten für Fett und Wasser, B1-Werte, Fettanteile für jedes Voxel und dergleichen liefern. Ersichtlich ermöglicht das Vorliegen von Magnetresonanzbildern 3, 4 zu unterschiedlichen Echozeiten 5, 6, an denen sich die relativen Phasen von Fettsignal und Wassersignal unterscheiden, zusätzliche Phaseninformation, die zur Trennung von Fett und Wasser in der Fingerprinting-Auswertung 22 beitragen, wobei die Fett-Wasser-Datenbank 23 ersichtlich auch bezüglich der Dimension der Phaseninformation ermittelt ist.

Es sei angemerkt, dass die Magnetresonanzbilder 3, 4 auch zur Anwendung einer Dixon-Technik geeignet sind, um unmittelbar Fettanteil und/oder Wasseranteil in den jeweiligen Voxeln bestimmen zu können. Auch Fettbilder und/oder Wasserbilder können entsprechend auf bekannte Art und Weise ermittelt werden. Beispielsweise können in diesem Kontext die Wasserbilder und die Fettbilder auch bezüglich der Fett-Datenbank 26 und der Wasser-Datenbank 27 einer Fingerprinting-Auswertung 22 in alternativen Ausführungsbeispielen unterzogen werden.

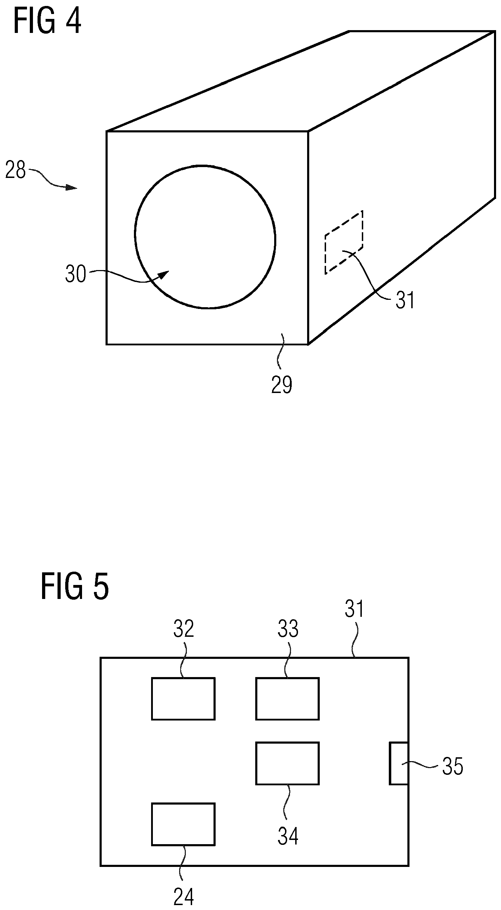

Fig. 4 zeigt eine Prinzipskizze einer erfindungsgemäßen Magnetresonanzeinrichtung 28, die, wie grundsätzlich bekannt, eine Hauptmagneteinheit 29 mit einer Patientenaufnahme 30 aufweist, in die ein Patient mittels einer hier nicht näher gezeigten Patientenliege eingefahren werden kann, um Magnetresonanzbilder 3, 4 des Untersuchungsbereichs des Patienten aufnehmen zu können. Weitere Komponenten der Magnetresonanzeinrichtung 28 können beispielsweise eine die Patientenaufnahme 30 umgebend angeordnete Hochfrequenzspulenanordnung und eine diese wiederum umgebende Gradientenspulenanordnung umfassen, sind jedoch der Übersichtlichkeit halber nicht näher dargestellt.

Der Betrieb der Magnetresonanzeinrichtung 28 wird durch eine Steuereinrichtung 31 gesteuert, die zur Durchführung eines erfindungsgemäßen Verfahrens eingerichtet ist. Die funktionale Struktur der Steuereinrichtung 31 ist in Fig. 5 genauer dargestellt.

Die Steuereinrichtung 31 weist zunächst eine Einstellungseinheit beziehungsweise Parametrierungseinheit 32 auf, über welche geeignete Echozeiten 5, 6 ermittelt werden können, und die Magnetresonanzsequenz entsprechend so ausgestaltet werden kann, dass die zwei Echos vermessen werden, mithin zwei Magnetresonanzbilder 3, 4 im Messvorgang entstehen. Dieser Messvorgang wird gesteuert durch eine grundsätzlich bekannte Sequenzeinheit 33. In einer Auswerteeinheit 34 kann die Fingerprinting-Auswertung 22, wie beschrieben, erfolgen, wobei auf die in dem Speichermittel 24 gespeicherte Fett-Wasser-Datenbank 23 zugegriffen werden kann. Die quantitativen Parameter 27 können dann über eine Schnittstelle 35 ausgegeben werden, beispielsweise als entsprechende Parameterkarten, insbesondere T1-Karten, T2-Karten, Fettanteilskarten und dergleichen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur quantitativen Magnetresonanzbildgebung, wobei wenigstens eine Aufnahmeserie von Magnetresonanzbildern (3, 4) eines Untersuchungsbereichs, der zwei unterschiedliche Spinarten, deren Larmorfrequenzen sich unterscheiden, insbesondere in Fett gebundene Protonen und in Wasser gebundene Protonen, aufweist, in Repetitionen (1) einer Magnetresonanzsequenz, die für jede Repetition (1) unterschiedliche Aufnahmeparameter nutzt, mit einer Magnetresonanzeinrichtung (28) aufgenommen wird, wobei in einer Fingerprintingauswertung (22) zur Ermittlung quantitativer Parameter (25) des Untersuchungsbereichs aus der Aufnahmeserie ermittelte Signalverläufe mit wenigstens aus einer Datenbank (23) ermittelten Vergleichsverläufen verglichen werden, **dadurch gekennzeichnet, dass** während jeder Repetition (1) wenigstens zwei Magnetresonanzbilder (3, 4) bei unterschiedlichen Echozeiten (5, 6), bei denen unterschiedliche relative Phasenlagen der Magnetisierung der Spinarten, insbesondere der in Fett gebundenen Protonen und der in Wasser gebundenen Protonen, vorliegen, aufgenommen werden.

2. Verfahren nach Anspruch 1, **dadurch gekennzeichnet, dass** eine Magnetresonanzeinrichtung (28) mit einem Grundmagnetfeld verwendet wird, dessen Stärke bei weniger oder gleich 1 T, insbesondere bei weniger oder gleich 0,75 T, liegt.

3. Verfahren nach Anspruch 1 oder 2, **dadurch gekennzeichnet, dass** wenigstens zwei der Echozeiten (5, 6) so gewählt werden, dass die Magnetisierung der Spinarten, insbesondere der in Fett gebundenen Protonen und der in Wasser gebundenen Protonen, einmal in Phase und einmal in Gegenphase vorliegt.

4. Verfahren nach einem der vorangehenden Ansprüche, **dadurch gekennzeichnet, dass** als Aufnahmetrajektorien für die Magnetresonanzbilder (3, 4) Spiraltrajektorien verwendet werden.

5. Verfahren nach Anspruch 4, **dadurch gekennzeichnet, dass** die Spiraltrajektorien verschiedener Magnetresonanzbilder (3, 4) im k-Raum unmittelbar aneinander anschließen.

6. Verfahren nach Anspruch 5, **dadurch gekennzeichnet, dass** eine nach außen durchlaufene Spirale für ein erstes Magnetresonanzbild (3, 4) und eine nach innen durchlaufene Spirale für ein zweites, unmittelbar folgendes Magnetresonanzbild (3, 4) verwendet wird oder dass eine Abfolge von nach innen und nach außen verlaufender Spiralen für ein erstes Magnetresonanzbild (3, 4) und eine nach innen verlaufende Spirale für ein zweites, unmittelbar folgendes Magnetresonanzbild (3, 4) verwendet werden.

7. Verfahren nach einem der vorangehenden Ansprüche, **dadurch gekennzeichnet, dass** als Ergebnis der Fingerprintingauswertung (22) für wenigstens einen Teil der in den Magnetresonanzbildern (3, 4) abgebildeten Voxel wenigstens ein Spinartanteil, insbesondere ein Fettanteil und/oder ein Wasseranteil, und/oder wenigstens ein das Magnetresonanzverhalten beschreibender Parameter für nur eine Spinart, insbesondere nur für den Fettanteil und/oder nur den Wasseranteil, ermittelt wird.

8. Verfahren nach einem der vorangehenden Ansprüche, **dadurch gekennzeichnet, dass** die Magnetresonanzbilder (3, 4) einer Repetition (1) zur Ermittlung wenigstens eines Spinartanteils, insbesondere eines Wasseranteils und/oder eines Fettanteils, des vermessenen Signals gemäß einer Dixon-Technik ausgewertet werden.

9. Magnetresonanzeinrichtung (28), aufweisend eine zur Durchführung eines Verfahrens nach einem der vorangehenden Ansprüche ausgebildete Steuereinrichtung (31) mit wenigstens einem Prozessor und einem Speichermittel (24).

10. Computerprogramm, welches die Schritte eines Verfahrens nach einem der Ansprüche 1 bis 8 durchführt, wenn es auf einer Steuereinrichtung (31) einer Magnetresonanzeinrichtung (28) ausgeführt wird.

11. Elektronisch lesbarer Datenträger, auf dem ein Computerprogramm nach Anspruch 10 gespeichert ist.
